# EUROPÄISCHE PATENTSCHRIFT

(11) **EP 1 868 951 B1**
(45) Veröffentlichungstag und Bekanntmachung des Hinweises auf die Patenterteilung: **30.03.2011**
(21) Anmeldenummer: 06743228.6
(22) Anmeldetag: 30.03.2006
(51) Int. Cl.: C03C 3/06, C03B 19/14, H01L 21/00

(54) **HALTER AUS QUARZGLAS FÜR DIE PROZESSIERUNG VON HALBLEITERWAFERN UND VERFAHREN ZUR HERSTELLUNG DES HALTERS**
HOLDER MADE FROM QUARTZ GLASS FOR THE PROCESSING OF SEMICONDUCTOR WAFERS AND METHOD FOR PRODUCTION OF THE HOLDER
SUPPORT EN VERRE DE QUARTZ DESTINE AU TRAITEMENT DE PLAQUETTES A SEMICONDUCTEURS ET PROCEDE DE FABRICATION DU SUPPORT

(30) Priorität: 15.04.2005 DE 102005017739
(43) Veröffentlichungstag der Anmeldung: 26.12.2007
(73) Patentinhaber: Heraeus Quarzglas GmbH & Co. KG, 63450 Hanau (DE)
(72) Erfinder: KUEHN, Bodo, 63571 Gelnhausen/Hailer (DE); POGGE, Tobias, 63179 Obertshausen (DE); TROMMER, Martin, 36381 Schlüchtern (DE); WEBER, Jürgen, 63801 Kleinostheim (DE); KIRST, Ulrich, 55116 Mainz (DE); WERDECKER, Waltraud, 63456 Hanau (DE)
(74) Vertreter: Staudt, Armin Walter
(86) Internationale Anmeldenummer: PCT/EP2006/061192
(87) Internationale Veröffentlichungsnummer: WO 2006/108766

(56) Entgegenhaltungen:
- EP-A- 0 546 196
- EP-A- 0 770 584
- EP-A- 1 586 544
- PATENT ABSTRACTS OF JAPAN Bd. 017, Nr. 513 (C-1111), 16. September 1993 (1993-09-16) -& JP 05 139779 A (ASAHI GLASS CO LTD), 8. Juni 1993 (1993-06-08)
- PATENT ABSTRACTS OF JAPAN Bd. 1998, Nr. 10, 31. August 1998 (1998-08-31) -& JP 10 114532 A (TOSHIBA CERAMICS CO LTD), 6. Mai 1998 (1998-05-06) in der Anmeldung erwähnt

## Beschreibung

Die Erfindung betrifft einen Halter aus Quarzglas für die Prozessierung von Halbleiterwafern.

Weiterhin betrifft die Erfindung ein Verfahren zur Herstellung eines derartigen Quarzglas-Halters.

Die Ausbeute und das elektrische Betriebsverhalten von Halbleiterbauelementen hängen wesentlich davon ab, inwieweit es bei der Halbleiterfertigung gelingt, Kontaminationen des Halbleitermaterials durch Verunreinigungen zu verhindern, die als "Halbleitergifte" wirken. Kontaminationen des Halbleitermaterials werden zum Beispiel durch die im Fertigungsprozess eingesetzten Apparaturen verursacht. Aufgrund der chemischen Beständigkeit von Quarzglas gegenüber vielen im Fertigungsprozess eingesetzten Substanzen und seiner relativ hohen Temperaturfestigkeit bestehen derartige Apparaturen häufig aus Quarzglas. An die Reinheit des Quarzglases werden daher hohe Anforderungen gestellt. Zunehmend werden die Apparaturen daher mit speziell gereinigten bzw. bearbeiteten Schichten versehen oder es wird synthetisch hergestelltes Quarzglas verwendet, das sich durch eine hohe Reinheit auszeichnet.

Ein Halter der eingangs genannten Gattung ist aus der JP 10114532 A bekannt. Darin ist ein sogenannter "Single-Wafer-Halter" aus synthetischem Quarzglas beschrieben, der sich durch einen geringen Gehalt an den Verunreinigungen Fe, Cu, Cr und Ni von jeweils weniger als 10 ppb und durch einen Hydroxylgruppengehalt im Bereich zwischen 100 und 1000 ppm auszeichnet.

Ein Quarzglas, das zur Herstellung von Haltern für die Verarbeitung von Halbleiterwafern geeignet ist, sowie ein Verfahren zu seiner Herstellung wird in EP 0 770 584 A1 offenbart. Das dort offenbarte Quarzglas ist mindestens im Oberflächenbereich mit Stickstoff dotiert, hat keine freien Hydroxylgruppen und seine Viskosität beträgt mindestens 3,16×10¹² dPa·s bei 1280°C.

Insoweit ist der bekannte Quarzglas-Halter für den Einsatz in Halbleiterfertigungsprozessen gut geeignet. Bei Plasma-Ätzprozessen, in denen die Halbleftersubstrate (Wafer) ätzend wirkenden Gasen und Plasmen, wie zum Beispiel CF₄, CHF₃, C₂F₆, C₃F₈, NF₃ oder SF₆ unterworfen werden, besteht jedoch ein weiteres Problem darin, dass das Quarzglas dabei langsam korrodiert wird. Es kommt zu einem Abtrag der Oberfläche und schließlich zu einem Volumenverlust, der zu einem Austausch des Quarzglas-Halters zwingt.

Ein ideales Quarzglas für einen Wafer-Halter zum Einsatz in ätzend wirkender Umgebung zeichnet sich daher sowohl durch hohe Reinheit als auch durch eine hohe Trockenätzbeständigkeit aus. Der Erfindung liegt die Aufgabe zugrunde, ein Quarzglas anzugeben, das diese Anforderungen weitgehend erfüllt, und ein wirtschaftliches Verfahren zur Herstellung eines derartigen Quarzglases bereitzustellen.

Hinsichtlich des Quarzglas-Halters wird diese Aufgabe ausgehend von dem eingangs genannten Halter erfindungsgemäß dadurch gelöst, dass das Quarzglas mindestens in einem oberflächennahen Bereich mit Stickstoff dotiert ist, einen mittleren Gehalt an metastabilen Hydroxylgruppen von weniger als 30 Gew.-ppm aufweist, und dass seine fiktive Temperatur unterhalb von 1250 °C und seine Viskosität bei einer Temperatur von 1200°C mindestens 10¹³ dPa·s betragen.

Für die Trockenätzbeständigkeit des Quarzglas-Halters ist in erster Linie der oberflächennahe Bereich entscheidend. Die folgenden Erläuterungen beziehen sich daher auf das Quarzglas in einer oberflächennahen Schicht des Halters mit einer Tiefe von mindestens 50 µm, wobei die Schicht im Grenzfall den gesamten Halter umfasst. Das Quarzglas weist folgende drei wesentlichen Merkmale auf:
- der mittlere Gehalt an metastabilen Hydroxylgruppen des Quarzglases beträgt weniger als 30 Gew.-ppm,
- die fiktive Temperatur des Quarzglases liegt unterhalb von 1250 °C_{,} und
- es zeichnet sich durch eine hohe Viskosität aus, die bei einer Temperatur von 1200 °C mindestens 10¹³ dPa·s beträgt.

Die Wirkungen dieser Merkmale hinsichtlich der oben genannten technischen Aufgabe werden im Folgenden näher erläutert:
- Es hat sich gezeigt, dass das Ätzverhalten von Quarzglas signifikant von seinem Hydroxylgruppengehalt bestimmt wird. Je geringer der Gehalt an Hydroxylgruppen ist (im Folgenden auch als "OH-Gruppen" bezeichnet), um so besser ist die Ätzbeständigkeit des Quarzglases gegenüber fluorhaltigen Substanzen. Diese Wirkung ist dadurch zu erklären, dass sich OH-Gruppen leichter protonieren lassen als die Si-O-Si-Gruppen des Quarzglasnetzwerkes. Durch den Säureangriff protonierte OH-Gruppen stellen im Quarzglasnetzwerk Abgangsgruppen dar, die sich durch einen nukleophilen Angriff des Fluoridanions leicht substituieren lassen. Das bedeutet, je mehr Hydroxylgruppen in der Quarzglasstruktur vorhanden sind, um so schneller wird das Quarzglasnetzwerk abgebaut. Die beim Ätzprozess ablaufende Bruttoreaktion lässt sich wie folgt beschreiben:

   Si-OH (Netzwerk) + HF → Si-(OH₂)⁺ + F⁻ → Si-F + H₂O (1)

Die höhere Ätzstabilität des Quarzglases macht sich jedoch erst bei einem Hydroxylgruppengehalt von weniger als 30 Gew.-ppm signifikant bemerkbar

Der OH-Gruppengehalt setzt sich zusammen aus chemisch fest gebundenen OH-Gruppen, die sich durch Tempern des Quarzglases nicht entfernen lassen, und aus chemisch weniger fest gebundenen OH-Gruppen, die durch eine Temperaturbehandlung aus dem Quarzglases "herausgetempert" werden können. Die letztgenannte Spezies von OH-Gruppen werden im Folgenden als "metastabile OH-Gruppen" oder "metastabile Hydroxylgruppen" bezeichnet.

Im Sinne dieser Erfindung wird als Gehalt an metastabilen OH-Gruppen derjenige OH-Gruppengehalt definiert, der nach einem Ausheizen eines Bauteils mit einer Dicke von 10 mm entweicht (Diffusionslänge ≤ 5mm), wenn das Ausheizen bei einer Temperatur von 1040 °C über einem Zeitraum von 48 Stunden und unter Inertgasspülung erfolgt.

Der Gehalt an metastabilen OH-Gruppen ergibt sich aus der Differenz des Hydroxylgruppengehalts vor und nach dem oben beschriebenen Ausheizen, durch Messung der IR-Absorption nach der Methode von *D. M. Dodd et al. "Optical Determinations of OH in Fused Silica", (1966),* S. 3911. Der Gehalt an metastabilen OH-Gruppen ist in jedem Fall kleiner als die angegebene Obergrenze, wenn der Gesamt-Hydroxylgruppengehalt des Quarzglases unterhalb dieser Obergrenze liegt.
- Weiterhin hat es sich gezeigt, dass das Ätzverhalten von Quarzglas wesentlich von seiner Glasstruktur bestimmt wird. Eine gute Ätzbeständigkeit ist nur zu erreichen, wenn gespannte Bindungen und Bindungswinkel im Quarzglasnetzwerk vermieden werden. Ein Parameter zur Charakterisierung der spezifischen Glasstruktur ist die "fiktive Temperatur". Damit wird der Ordnungszustand des "eingefrorenen" Glasnetzwerkes beschrieben. Eine höhere fiktive Temperatur des Quarzglases geht mit einem geringeren Ordnungszustand der Glasstruktur und einer größeren Abweichung von der energetisch günstigsten Anordnung einher. Bei Quarzglas mit einer fiktiven Temperatur oberhalb von 1300 °C macht sich der energetisch ungünstigere Zustand der Glasstruktur deutlich in Form einer höheren Ätzrate bemerkbar.

Ein gängiges Messverfahren zur Ermittlung der fiktiven Temperatur anhand einer Messung der Raman-Streuintensität bei einer Wellenzahl von etwa 606 cm⁻¹ ist in "Ch. Pfleiderer et. al.; The UV-induced 210 nm absorption band in fused silica with different thermal history and stoichiometry; Journal of Non-Cryst. Solids 159 (1993), S. 143-145" beschrieben.
- Außerdem wurde gefunden, dass die Ätzbeständigkeit des Quarzglases signifikant von seiner Viskosität abhängt. Eine hohe Viskosität geht mit einer hohen Ätzbeständigkeit einher. Daher zeichnet sich das erfindungsgemäße Quarzglas außerdem durch eine hohe Viskosität aus, die bei einer Temperatur von 1200 °C mindestens 10¹³ dPa·s beträgt.

Beim bestimmungsgemäßen Einsatz wird der Quarzglas-Halter keinen hohen Temperaturen nahe des Erweichungsbereiches Quarzglas unterzogen. Die üblichen Temperaturbelastungen liegen zwischen Raumtemperatur und ca. 300 °C, so dass die Temperaturbeständigkeit des Quarzglases bei der vorliegenden Erfindung keine wesentliche Rolle spielt.
- Eine weitere wesentliche Einflussgröße für die Ätzresistenz des Quarzglases stellen Dotierstoffe dar. Es hat sich als vorteilhaft erwiesen, wenn das Quarzglas mindestens in einem oberflächennahen Bereich mit Stickstoff dotiert ist.

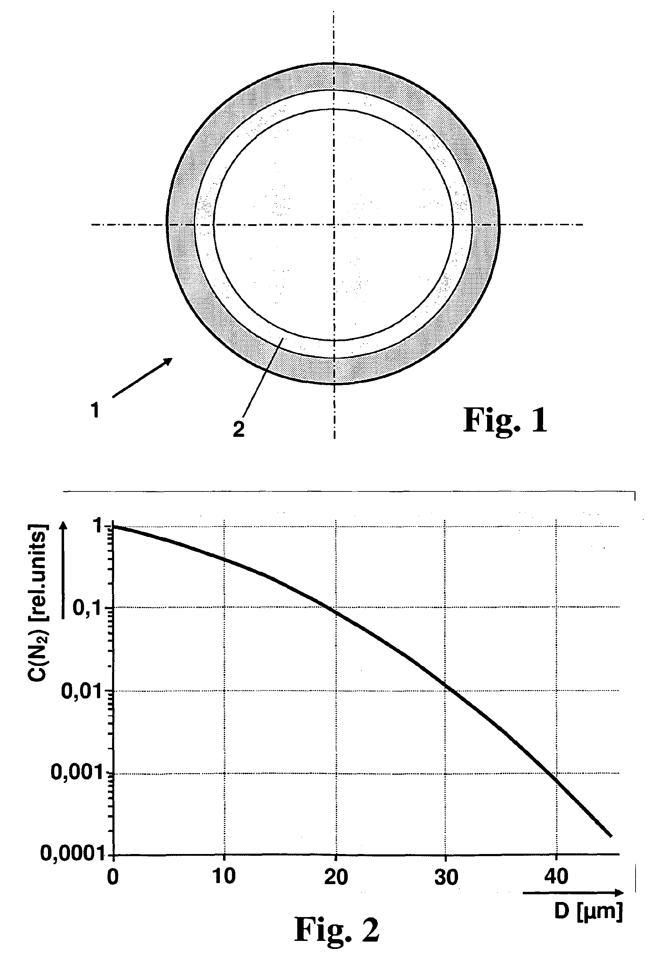

Eine Stickstoffdotierung des Quarzglases bewirkt bekanntermaßen eine Erhöhung der Viskosität und demgemäß auch eine erhöhte Ätzresistenz. Sofern die Stickstoffdotierung des Quarzglases durch Eindiffusion von einer freien Oberfläche aus erzeugt wird, stellt sich innerhalb des Quarzglases zwangsläufig ein spezifisches Diffusionsprofil von Stickstoff ein, wie im Diagramm von Figur 2 dargestellt. Aus dem Diffusionsprofil und dem Anfangswert unmittelbar an der Halter-Oberfläche kann der mittlere Stickstoffgehalt des Quarzglases in der gesamten Oberflächenschicht (50 µm) ermittelt werden. Bei einer durch XPS-Analyse ermittelten Stickstoffkonzentration auf Basis der obersten 5 nm der Oberfläche hat sich als ausreichend erwiesen, wenn dort eine Stickstoffkonzentration von 10 Atom-% gemessen wird.

Wasserstofffreie Syntheseverfahren zur Herstellung von synthetischem Quarzglas mit extrem geringem Gesamt-Hydroxylgruppengehalt sind allgemein bekannt. Als Beispiel sei die plasmaunterstützte Oxidation und Abscheidung von SiO₂ in wasserstofffreier Atmosphäre genannt. Mittels derartiger Verfahren sind Hydroxylgruppengehalte im ppb-Bereich erzielbar, wie sie für Lichtwellenleiteranwendungen notwendig sind. Das so hergestellte Quarzglas ist jedoch sehr teuer und deshalb für den Masseneinsatz bei der Halbleiterherstellung nicht geeignet.

In der Regel wird synthetisches Quarzglas mittels des sogenannten Flammhydrolyseverfahrens aus siliziumhaltigen Ausgangsstoffen unter Einsatz von Abscheidebrennern auf Knallgasbasis hergestellt. Dabei werden in das Quarzglas große Mengen an Hydroxylgruppen eingebracht. Diese lassen sich in einem zweistufigen Prozess mit einem Zwischenprodukt in Form eines porösen SiO₂-Körpers (Sootkörper) nachträglich relativ leicht entfernen, zum Beispiel durch eine Dehydratationsbehandlung unter Einsatz von Halogenen.

Es wurde jedoch gefunden, dass die Dehydratation poröser SiO₂-Körper in halogenhaltiger Atmosphäre entweder zu schwachen Netzwerkbindungen oder zu einer geringen Dichte des Quarzglases führt, und dass beide Effekte mit einer geringen Ätzstabilität des resultierenden Quarzglases einhergehen.

Aus den genannten Gründen ist bei einer ersten bevorzugten Ausführungsform des erfindungsgemäßen Halters das Quarzglas aus natürlich vorkommendem Si-O₂-Rohstoff erschmolzen, wobei der mittlere Gehalt an metastabilen Hydroxylgruppen weniger als 5 Gew.-ppm beträgt.

Das Quarzglas wird hierbei aus natürlich vorkommenden Rohstoffen erschmolzen, wobei darauf zu achten ist, dass während des Herstellprozesses möglichst wenig Hydroxylgruppen in das Quarzglas eingebracht werden, oder dass diese zumindest nachträglich noch entfernt werden können.

Von den oben erläuterten Einflussgrößen wirken sich die Viskosität und der Hydroxylgruppengehalt am deutlichsten auf das Ätzverhalten des Quarzglases aus. Vorzugsweise liegt der mittlere Gehalt an metastabilen Hydroxylgruppen des natürlichen Quarzglases daher bei maximal 1 Gew.-ppm.

Bei einer weiteren bevorzugten Ausführungsform des erfindungsgemäßen Quarzglas-Halters ist das Quarzglas aus synthetisch erzeugtem SiO₂ erschmolzen, mit der Maßgabe, dass es einen mittleren Stickstoffgehalt von mindestens 0,1 At.-% aufweist.

Infolge der oben erwähnten Problematik beim Dehydratisieren von synthetischem Quarzglas unter Einsatz von Halogenen kann ein sehr geringer Hydroxylgruppengehalt mit anderen Nachteilen einhergehen, wie beispielsweise einer geringen Dichte oder einem hohen Chlorgehalt. Eine akzeptable Ätzbeständigkeit wird bei synthetischem Quarzglas jedoch in jedem Fall erreicht, wenn das Glas einen mittleren Stickstoffgehalt von mindestens 0,1 Atom-% aufweist.

Synthetisches Quarzglas mit einem geringen Gesamt-Hydroxylgruppengehalt wird in der Regel hergestellt, indem ein durch Flammenhydrolyse von SiCl₄ hergestellter SiO₂-Sootkörper bei einer Temperatur von 1200 °C in einer chlorhaltigen Atmosphäre dehydratisiert und anschließend bei hoher Temperatur unter Vakuum zu einem transparenten Quarzglasrohling verglast wird.

Chlor kann Hydroxylgruppen im Quarzglasnetzwerk leicht substituieren, so dass deren Gehalt durch diese Art der Dehydratationsbehandlung relativ einfach auf sehr geringe Werte gesenkt werden kann. Allerdings kommt es dabei zu einem Einbau von Chlor in das Glasnetzwerk, was sich auf die Trockenätzbeständigkeit ungünstig auswirkt. Ähnliches ergibt sich bei der Dehydratation mittels anderer Halogene oder deren Verbindungen, insbesondere mittels Fluor. Andererseits erfordert eine rein physikalische - und nicht chemisch unterstützte - Absenkung des Hydroxylgruppengehalts auf Werte unterhalb von 50 Gew.-ppm lange Behandlungsdauern bei hohen Temperaturen. Es hat sich gezeigt, dass es dabei zu Umordnungen der Glasstruktur und zu Defektbildungen kommen kann, insbesondere zu Sauerstoffdefektstellen, wobei eine Ursache dafür darin liegen kann, dass für die entfernten OH-Gruppen ein geeigneter Substituent nicht unmittelbar zu Verfügung steht. Die so erzeugten Sauerstoffdefektstellen sind für die Trockenätzbeständigkeit des Quarzglases jedoch weniger schädlich als ein hoher Chlorgehalt.

Ein synthetisches Quarzglas wird daher bevorzugt erzeugt, indem ein Sootkörper bei hoher Temperatur um 1200 °C thermisch getrocknet wird, derart, dass sich ein mittlerer Gesamt-Hydroxylgruppengehalt von weniger als 30 Gew.-ppm einstellt. Durch diese thermische Dehydratationsbehandlung wird ein übermäßiger Eintrag von Halogenen in den Sootkörper im Rahmen der Substitution von Hydroxylgruppen vermieden. Anschließend wird der Sootkörper wie üblich verglast. Dabei diffundiert der vorhandene molekulare Wasserstoff aus, der beim Flammhydrolyseverfahren herstellungsbedingt in das Quarzglas eingebracht wird, und der andernfalls bei nachfolgenden Heißbehandlungsschritten zu unerwünschten SiH-Gruppen weiter reagieren würde, die sich im Verlauf der weiteren Bearbeitungsschritte nachteilig bemerkbar machen und zu einer Verschlechterung des Trockenätzverhaltens des Quarzglases führen würden. Das Vakuum dient zur Beschleunigung des Ausgasungsvorgangs. Nach dem Verglasen liegt ein Quarzglasrohling mit einem Gesamt-Hydroxylgruppengehalt von weniger als 30 Gew.-ppm vor, der im Wesentlichen frei Sauerstoff-Fehlstellen, von SiH-Gruppen und von Wasserstoff ist (der Gehalt aller dieser Komponenten liegt unterhalb der Nachweisgrenze). Der Quarzglasrohling wird anschließend getempert, wobei auf die Einstellung einer fiktiven Temperatur im Bereich zwischen 1040 °C und 1200 °C geachtet wird. Die vorgegebene fiktive Temperatur kann erhalten werden, indem der Quarzglasrohling bei einer Temperatur im Bereich der gewünschten fiktiven Temperatur bis zur Einstellung des strukturellen Gleichgewichtes gehalten und danach rasch abgekühlt wird, oder indem der Rohling von einer Temperatur oberhalb der einzustellenden fiktiven Temperatur ausreichend schnell abgekühlt wird.

Es hat sich als besonders vorteilhaft erwiesen, wenn das Quarzglas einen Gehalt an Fluor von weniger als 50 Gew.-ppm und an Chlor von weniger als 60 Gew.-ppm aufweist.

Fluor- und Chlor-Dotierungen vermindern die Dichte von Quarzglas und beeinträchtigen dadurch die Ätzbeständigkeit. Fluor oder Chlor können außerdem in der Verbindungen von Silicium leicht protoniert oder substituiert werden und beschleunigen dabei den Abbau der Netzwerkstruktur. Im Fall von natürlichem Quarzglas erfolgt die quantitative Analyse von Fluor- oder Chlor häufig durch Anlayseverfahren wie ICP-AES (inductive coupled plasma atomic (optical) emission spectroscopy) oder ICP-AAS (inductive coupled plasma atomic (optical) absorption spectroscopy), wobei die Nachweisbarkeitsgrenze für Fluor bei etwa 50 Gew.-ppm liegt und für Chlor bei etwa 60 Gew.-ppm. Die tatsächlichen Konzentrationen dieser Substanzen in natürlichem Quarzglas können je nach Vorbehandlung des Rohstoffes jedoch deutlich unterhalb dieser Nachweisbarkeitsgrenzen liegen. Bei synthetischem Quarzglas wird für die quantitative Analyse von Fluor- oder Chlor in der Regel die Raman-Spektroskopie eingesetzt, mittels der Gehalte dieser Substanzen im ppb-Bereich zu quantifizieren sind.

Es hat sich auch als günstig erwiesen, wenn das Quarzglas einen Gehalt an SiH-Gruppen von weniger als 1x10¹⁷ pro cm³ Glas aufweist.

Defektzentren reduzieren die Ätzbeständigkeit von Quarzglas gegenüber Flusssäure. In dieser Hinsicht haben sich insbesondere die SiH-Gruppen als besonders nachteilig erwiesen, wobei deren Reaktion mit Flusssäure sich anhand folgender Reaktionsgleichung beschreiben lässt:

Si-H (Netzwerk) + HF → Si-F + H₂ (2)

Alternativ dazu ist es auch vorstellbar, dass die SiH-Gruppen mit Wasser zunächst zu SiOH- reagieren und dann die oben genannte Reaktion (1) abläuft. SiH-Gruppen sind gegenüber einem chemischen Angriff sterisch weniger gehindert als SiOH-Gruppen und insofern ebenfalls bevorzugte Angriffsstellen von fluorhaltigen Ätzmitteln.

Eine besonders geeignete Ausführungsform des erfindungsgemäßen Quarzglas-Halters zeichnet sich dadurch aus, dass das Quarzglas für UV-Strahlung einer Wellenlänge von 163 nm eine Absorption von weniger als 0,5/cm aufweist.

Eine Absorption bei dieser Wellenlänge ist auf ein Defektzentrum der Netzwerkstruktur in Form einer Sauerstoff-Fehlstelle, einer Si-Si-Gruppe, zurückzuführen. Es hat sich gezeigt, dass auch derartige Fehlstellen die Ätzresistenz gegenüber fluorhaltigen Ätzmitteln verringern.

Sogenannte Netzwerkwandler, wie Alkali-Ionen, lockern die Netzwerkstruktur von Quarzglas bereits in geringer Konzentration deutlich und verringern dessen Ätzresistenz. Daher hat es sich als vorteilhaft erwiesen, wenn der Gehalt an Na und K im Quarzglas maximal 500 Gew.-ppb beträgt.

Andererseits es hat sich bewährt, wenn das Quarzglas Aluminiumoxid enthält, wobei der Al-Gehalt im Bereich zwischen 5.000 Gew.-ppm und 20.000 Gew.-ppm liegt (bezogen auf Al, nicht auf Al₂O₃).

Eine Dotierung mit Aluminiumoxid erhöht die Ätzresistenz des Quarzglases. Allerdings geht ein hoher Al-Gehalt herstellungsbedingt häufig auch mit einem hohen Hydroxylgruppengehalt einher, da das Al-dotierte Quarzglas in der Regel durch Flammenschmelzverfahren unter Einsatz einer wasserstoff haltigen Brennerflamme erschmolzen wird, um Entmischungen zu vermeiden. Derartiges Al-dotiertes Quarzglas mit gleichzeitig hohem Hydroxylgruppengehalt fällt unter ein Materialklasse, die nicht Gegenstand der vorliegenden Erfindung ist.

Hinsichtlich des Verfahrens wird die oben genannte Aufgabe erfindungsgemäß durch ein Verfahren gelöst das folgende Verfahrensschritte umfasst:
- ein Bereitstellen von SiO₂-Rohstoff in Teilchenform, vorzugsweise aus natürlich vorkommendem Rohstoff,
- ein Schmelzen oder Sintern des SiO₂-Rohstoffs zu einem Quarzglas-Rohling, wobei der SiO₂-Rohstoff oder der Quarzglas-Rohling einer Entwässerungsmaßnahme unterzogen werden,
- ein Erhitzen des SiO₂-Rohstoffs oder des Quarzglas-Rohlings auf eine Nitridierungstemperatur im Bereich zwischen 1050 °C und 1850 °C unter einer Ammoniak enthaltenden Atmosphäre,
- eine Temperaturbehandlung, mittels der das Quarzglas des Quarzglas-Rohlings auf eine fiktive Temperatur von 1250 °C oder weniger eingestellt wird, und
- eine Oberflächenbehandlung des Quarzglas-Rohlings unter Bildung des Quarzglas-Halters.

Das erfindungsgemäße Verfahren dient zur Herstellung eines erfindungsgemäßen Quarzglas-Halters mit den oben erläuterten Eigenschaften und Wirkungen unter Einsatz von synthetischem, vorzugsweise natürlichem Rohstoff.

Im bevorzugten Fall wird zunächst ein Quarzglas-Rohling aus vorkommendem, gereinigtem Rohstoff erschmolzen. Für natürlichen Rohstoff in Form von Quarzkristallen ist ein geringer Gehalt an Hydroxylgruppen charakteristisch. Durch die Wahl dieses Rohstoffes ergibt sich daher bereits ein vergleichsweise geringer Gesamt-Hydroxylgruppengehalt im Quarzglas, ohne dass hierfür ein aufwändiges wasserfreies Syntheseverfahren oder die Dehydratationsbehandlung eines porösen Sootkörpers, mit der oben erläuterten Folgen der Bildung schwacher Netzwerkbindungen oder einer geringen Dichte des Quarzglases, erforderlich sind, wie es für synthetisches Quarzglas typisch ist. Dennoch bedarf auch das Herstellungsverfahren unter Einsatz von natürlichem Rohstoff einer besonderen Entwässerungsmaßnahme, um ein Quarzglas mit einem Gehalt an metastabilen Hydroxylgruppen von weniger als 30 Gew.-ppm, vorzugsweise weniger als 5 Gew.-ppm, und besonders bevorzugt weniger als 1 Gew.-ppm zu erzielen.

Zum Zweck einer Dotierung des Quarzglases mit Stickstoff, die zu einer Erhöhung der Viskosität bei hohen Einsatztemperaturen und zu einer höheren Ätzresistenz des Quarzglases beiträgt, werden der SiO₂-Rohstoff oder der Quarzglas-Rohling unter einer Ammoniak enthaltenden Atmosphäre erhitzt.

Dadurch wird eine effektive Stickstoffdotierung des Rohstoffs oder zumindest der oberflächennahen Quarzglasschicht des Rohlings erreicht, die zu einer Erhöhung der Viskosität bei hohen Einsatztemperaturen und zu einer höheren Ätzresistenz des Quarzglases beiträgt.

Bei Nitridierungstemperaturen unterhalb von 1050 °C ist die Nitridierungsgeschwindigkeit vergleichsweise gering und auf einen dünnen Oberflächenbereich beschränkt.

Weiterhin ist eine Temperaturbehandlung erforderlich, um das Quarzglas des Quarzglas-Rohlings auf eine fiktive Temperatur von 1250 °C oder weniger einzustellen. Für die Temperbehandlung ist ein langsames Abkühlen des Quarzglases im Temperaturbereich zwischen 1450 °C und 1100 °C charakteristisch, so dass strukturelle Umordnungen der Glasstruktur ermöglicht werden.

Anschließend erfolgt eine Oberflächenbehandlung des Quarzglas-Rohlings unter Bildung des Quarzglas-Halters. In der Regel erfolgt die Endmaßbearbeitung des Rohlings durch mechanischen Abtrag. Das Glätten der mechanisch bearbeiteten Oberfläche kann durch chemisches Ätzen oder durch eine Feuerpolitur erfolgen. Die Oberflächenbehandlung kann auch ein Erhitzen des Rohlings unter einer Ammoniak enthaltenden Atmosphäre umfassen.

Die Weiterverarbeitung des Rohlings zum erfindungsgemäßen Quarzglas-Halter umfasst eine Oberflächenbehandlung, beispielsweise eine mechanische, thermische oder chemische Nachbehandlung des Rohlings durch Dotieren, Verglasen, Schleifen, Schneiden oder Polieren, auch Flammenpolieren. Die Weiterverarbeitung kann außerdem ein Tempern oder plastische Umformschritte beinhalten.

Es hat sich als vorteilhaft erwiesen, wenn die Nitridierungstemperatur beim Erhitzen des SiO₂-Rohstoffs oder des Quarzglas-Rohlings maximal 1250 °C beträgt.

Bei Temperaturen oberhalb von 1250 °C ergibt sich durch die Zersetzung von Ammoniak und die Anwesenheit von Wasserstoff ein merklicher Einbau von Hydroxylgruppen, was zu einer Abnahme der Ätzbeständigkeit des Quarzglases führt. Im Hinblick auf diese gegenläufigen Effekte wird bei Quarzglas aus natürlichen Rohstoffen eine optimale Ätzbeständigkeit bei einer Nitridierungstemperatur im Bereich zwischen 1080 °C und 1120 °C und bei synthetischem Quarzglas bei einer Nitridierungstemperatur im Bereich zwischen 1130 °C und 1170 °C erreicht.

Es hat sich als günstig erwiesen, wenn die Entwässerungsmaßnahme ein Schmelzen oder Sintern des SiO₂-Rohstoffs in einer grafithaltigen Form umfasst.

Der Kohlenstoff der grafithaltigen Form wirkt entwässernd auf Quarzglas und entfernt daher sehr effektiv Hydroxylgruppen. Gleichermaßen wirkt eine Entwässerungsmaßnahme, die ein Schmelzen oder Sintern des SiO₂-Rohstoffs in einer wasserfreien Atmosphäre oder unter Vakuum umfasst.

Gleichermaßen vorteilhaft wirkt eine Entwässerungsmaßnahme, die ein Tempern des Quarzglas-Rohlings unter Vakuum umfasst.

Durch ein Tempern des Rohlings bei Temperaturen von mehr als 1000 °C (genauer 1040 °C) und über einen Zeitraum von mehreren Stunden werden im Oberflächenbereich des Quarzglas-Rohlings vorhandene, metastabile OH-Gruppen entfernt.

In ähnlicher Weise wirkt auch eine bevorzugte Verfahrensweise, bei der die Entwässerungsmaßnahme das Erhitzen des SiO₂-Rohstoffs oder des Quarzglas-Rohlings auf die Nitridierungstemperatur unter Ammoniak-Atmosphäre umfasst.

Dabei stellt sich außer der Entwässerung durch Beseitigung metastabiler OH-Gruppen gleichzeitig eine gewünschte Beladung des Quarzglases mit Stickstoff.

Eine weitere Verbesserung ergibt sich, wenn die Oberflächenbehandlung ein Erhitzen der Rohling-Oberfläche unter Einsatz eines auf die Oberfläche lokal einwirkenden Laserstrahls oder Hochtemperatur-Plasmas umfasst.

Durch lokales Erhitzen auf eine hohe Temperatur unter Einsatz eines Lasers oder einer Plasmaeinrichtung kommt es zu lokalem Aufschmelzen des oberflächennahen Quarzglases, so dass vorhandene Mikrorisse beseitigt und eine glatte, feuerpolierte Oberfläche erhalten wird, die während des bestimmungsgemäßen Einsatzes des Quarzglas-Halters wenig Partikel an die Umgebung abgibt. Da nur lokale Bereiche der Oberfläche erhitzt und erweicht werden, werden durch die Behandlung nur geringe mechanische Spannungen in das Halter eingebracht, die sich weder in einer Änderung der fiktiven Temperatur bemerkbar machen und die auch keine Verformungen des Halters bewirken. Dabei ist es im Hinblick auf einen geringen Hydroxylgruppengehalt und eine hohe Ätzresistenz besonders vorteilhaft, wenn die Behandlung unter Ausschluss von Wasser und Wasserstoff erfolgt, so dass ein Einbau von Hydroxylgruppen in das aufgeschmolzen Quarzglas verhindert wird.

Außerdem wird eine bessere Ätzresistenz des Quarzglas-Halters erreicht, wenn die Oberflächenbehandlung eine mechanische Oberflächenbearbeitung umfasst, wodurch eine anfängliche mittlere Oberflächenrauigkeit R_{a,0} von 0,2 µm oder mehr eingestellt wird, und wobei von der durch mechanische Bearbeitung erhaltenen Oberfläche in einer anschließenden Ätzbehandlung mindestens 10 µm abgetragen werden.

Allein durch dieses Maßnahme, die in der DE 10 2005 005 196.0 näher erläutert ist, wird eine deutliche Verbesserung der Ätzresistenz des Halters erreicht. Die so vorbehandelte Quarzglasoberfläche ist zur Durchführung der weiter oben erläuterten Maßnahmen, wie beispielsweise der Dotierung mit Stickstoff, besonders gut geeignet.

Nachfolgend wird die Erfindung anhand eines Ausführungsbeispiels und einer Patentzeichnung näher beschrieben. Dabei zeigen im Einzelnen:
- **Figur 1**: eine Ausführungsform des erfindungsgemäßen Quarzglas-Halters zum Einsatz als Single-Wafer-Halter bei der Halbleiterfertigung in schemati- scher Darstellung, und
- **Figur 2**: ein Diagramm, das ein theoretisch ermitteltes Diffusionsprofil für die Eindiffusion von Stickstoff von der Oberfläche eines Quarzglas-Halters zeigt.

**Figur 1** zeigt einen Single-Wafer-Halter 1 aus Quarzglas für die Prozessierung von 8 Zoll-Wafern. Der Halter 1 besteht im Wesentlichen aus einem Quarzglasring mit einem Außendurchmesser von 256 mm und mit einem Innendurchmesser von 196 mm, der mit einer umlaufenden Vertiefung 2 zur Aufnahme des Wafers versehen ist.

Bei allen nachfolgenden Beispielen wird jeweils von einem Quarzglas-Halter ausgegangen, bei dem die beiden Flachseiten und die Zylinderflächen geschliffen sind, wobei die mittlere Oberflächenrauigkeit (Rₐ-Wert) 0,8 µm beträgt.

Die Proben wurden verschiedenen Nachbehandlungen unterzogen, um den Halter insgesamt oder speziell seine Oberfläche hinsichtlich der Trockenätzbeständigkeit zu verbessern. Die Nachbehandlungen sind für jede Probe in Tabelle 1 aufgeführt. Die Viskositätsangaben in der Tabelle beziehen sich auf eine Temperatur von 1200 °C und auf stickstoffdotiertes Quarzglas, sofern die betreffende Probe mit Stickstoff dotiert ist. Hinsichtlich der Stickstoffdotierung wird unterschieden zwischen einer Dotierung des oberflächennahen Bereiches, wobei die mittels XPS-Messung ermittelten Stickstoffgehalte in der vorletzten Zeile von Tabelle 1 angegeben sind, und einer Dotierung des gesamten Volumens (nur Probe S4). Im Folgenden werden die Nachbehandlungen näher erläutert:

### Lang andauerndes Nassätzen in HF-Lösung

Hierbei wird der Quarzglas-Halter nach dem Schleifen 1440 Minuten lang in 10%-iger HF-Lösung behandelt, so dass sich eine Ätzstruktur mit einer mittleren Oberflächenrauigkeit Rₐ um 4,3 µm einstellt, die vollkommen frei von Mikrorissen ist. Ein charakteristisches Merkmal des so hergestellten Quarzglas-Halters zeigt sich bei weiterem Ätzen in 10%-iger Flusssäure in einer im Vergleich zum unbehandelten Quarzglas deutlich geringeren und in etwa zeitlich konstanten Gewichtsabnahme.

### Hydroxylgruppen-freies Glätten durch Laserpolitur

Anstelle der Ätzbehandlung in Flusssäure wird der Halter 1 nach dem Schleifen mittels eines CO₂-Lasers in einer wasserstofffreien Atmosphäre verglast. Hierbei wird der Laserstrahl mittels einer Optik aufgeweitet und entlang der Quarzglas-Oberfläche bewegt. Dabei wird die Oberfläche lokal erhitzt und erweicht und es wird eine flammenpolierte Oberfläche ohne zusätzlichen Einbau von Hydroxylgruppen erhalten.

### Stickstoffdotierung der Oberfläche

Hierbei wird der Quarzglas-Halter während einer Dauer von 2 Stunden bei einer Temperatur von 1100 °C in Ammoniak-Atmosphäre behandelt. Dadurch ergibt sich eine Stickstoffbeladung im oberflächennahen Bereich, die durch eine XPS-Messung quantifiziert wird. Die in der Tabelle 1 genannten Stickstoffgehalte beziehen sich jeweils auf einen oberflächennahen Schichtdickenbereich von 5 nm bis 10 nm. Daraus kann anhand Figur 2 das Stickstoffkonzentrations-Profil über die Schichtdicke ermittelt werden. In Tabelle 1 ist eine gegebenenfalls durchgeführte Stickstoffbeladung im oberflächennahen Bereich in der vorletzten Zeile angegeben, wobei die Ziffer hinter dem Schrägstrich die durch XPS-Analyse ermittelte Stickstoff-Konzentration an der Oberfläche bezeichnet.

### Ermittlung des Trockenätzverhaltens

Für alle in Tabelle 1 genannten Quarzglas-Proben wurde das Trockenätzverhalten ermittelt. Hierzu wurden entsprechende Proben in einer Plasma-Ätzkammer zusammen mit einer Referenzprobe einem Standard-Ätzprozess unterzogen. Bei der Referenzprobe handelt es sich um thermisch aufgewachsens SiO₂, das sich bei Trockenätzprozessen durch Abscheidung von Silizium und anschließender Oxidation zu Siliziumdioxid bildet. Zur Feststellung einer Ätztiefe wurde jeweils ein Bereich der Probe mit einem ätzresistenten Film abgedeckt. Das Trockenätzverhalten ist hier definiert als das Verhältnis der Tiefen der nach dem Ätzprozess erhaltenen Ätzstufen bei der Probe und bei der Referenzprobe. Die so ermittelte dimensionslose Maßzahl wurde wiederum auf diejenige Maßzahl bezogen, die das Trockenätzverhalten des bisherigen Standardmaterials wiedergibt. Dieses Standardmaterial besteht aus Quarzglas aus natürlichem Rohstoff, das in einem mehrstufigen Prozess erzeugt wird, der ein Ziehen eines Quarzglasstrangs aus der Schmelze und mehrere Umformprozesse umfasst. In der unten stehenden Tabelle 1 ist ein ähnliches Quarzglas als Probe "N8" bezeichnet, wobei das Quarzglas der Probe N8 ergänzend zum Standardmaterial zur Verbesserung der Trockenätzbeständigkeit einer Temperbehandlung zur Einstellung einer niedrigen fiktiven Temperatur sowie einer besonderen Oberflächenglättung unterzogen worden ist, und darüber hinaus im oberflächennahen Bereich mit Stickstoff dotiert worden ist.

Die so ermittelte Maßzahl für das Trockenätzverhalten der jeweiligen Quarzglas-proben ist in der letzten Zeile von Tabelle 1 angegeben. Je kleiner die Maßzahl, um so besser das Trockenätzverhalten des jeweiligen Quarzglases. Aus Tabelle 1 sind auch die jeweilige chemische Zusammensetzung der Quarzgläser und deren spezifischen Behandlungen und die sich daraus ergebenden Änderungen der Maßzahl ersichtlich.

### Beispiel 1 (Probe N1)

Es wird ein Quarzglas-Halter 1 aus natürlichem vorkommendem, teilchenförmigem Quarz erschmolzen und geschliffen wie oben erläutert.

Als Ausgangsmaterial wird natürlich vorkommender, teilchenförmiger Quarzkristall eingesetzt und durch Heißchlorieren bei hoher Temperatur (ca. 1050 °C) gereinigt.

Die SiO₂-Körnung wird anschließend in eine Grafitform gegeben und bei einer Temperatur von 1800 °C durch Gasdrucksintern verglast. Hierbei wird die Form zunächst unter Aufrechterhaltung eines Unterdrucks von < 1 mbar auf die Sintertemperatur von 1800 °C aufgeheizt. Nach Erreichen der Sintertemperatur wird im Ofen ein Überdruck von 10 bar eingestellt und die Form bei dieser Temperatur ca. 3 h lang gehalten. Das anschließende Abkühlen auf eine Temperatur von 400 °C erfolgt mit einer Abkühlrate von 2 °C/min, wobei der Überdruck weiter aufrecht erhalten wird. Danach erfolgt das freie Abkühlen auf Raumtemperatur. Dieses Herstellungsverfahren ist in der Tabelle 1 als "Vakuumschmelzen" bezeichnet.

Es wird ein Hohlzylinder aus transparentem Quarzglas mit den in Tabelle 1 unter N1 genannten Eigenschaften erhalten. Zur Herstellung eines Quarzglas-Halters im Sinne der Erfindung wird davon ein Ring abgetrennt und wie eingangs beschrieben geschliffen und anschließend einem lang andauernden Nassätzen in HF-Lösung unterzogen.

Das so erhaltene Quarzglas zeichnet sich durch eine vergleichsweise hohe Trockenätzbeständigkeit aus, die vor dem Ätzprozess in 10%-iger HF-Lösung gemäß dem oben beschriebenen Verfahren durch eine Maßzahl von 0,74, und nach dem Ätzprozess durch eine Maßzahl von 0,59 gekennzeichnet ist

### Beispiel 2 (Probe N1)

Der Quarzglas-Halter 1 gemäß Beispiel 1 wird nach der Ätzbehandlung zusätzlich einer Stickstoffdotierung der Oberfläche unterzogen. Durch XPS-Messung ergibt sich in einem oberflächennahen Schichtdickenbereich von 5 nm bis 10 nm eine Stickstoffkonzentration von 19 Atom-%.

Durch diese Dotierung kann die Trockenätzbeständigkeit des Quarzglases gegenüber Beispiel 1 weiter verbessert werden, so dass sich eine Maßzahl von 0,33 einstellt.

### Beispiel 3 (Probe N2)

Es wird ein Quarzglas-Halter 1 wie anhand Beispiel 1 beschrieben hergestellt. Die Probe N2 unterscheidet sich von der Probe N1 lediglich durch einen etwas höheren Hydroxylgruppengehalt, der sich durch eine etwa weniger intensive Dehydratationsbehandlung einstellt. Infolgedessen ergeben sich auch eine höhere Viskosität bei dem Quarzglas der Probe N2 sowie jedoch eine etwas geringere fiktive Temperatur.

Anstelle der Ätzbehandlung in Flusssäure wird der Halter 1 nach dem Schleifen einem hydroxylgruppenfreien Glätten durch Laserpolitur unterzogen, so dass es eine flammenpolierte Oberfläche ohne zusätzlichen Einbau von Hydroxylgruppen erreicht wird.

Der so behandelte Quarzglas-Halter zeigt ein Trockenätzverhalten, das durch einen Maßzahl von 0,67gekennzeichnet ist. Durch eine anschließende Stickstoffdotierung der Oberfläche durch Behandlung in Ammoniak-Atmosphäre, die anhand einer XPS-Messung in einem oberflächennahen Schichtdickenbereich von 5 nm bis 10 nm eine Stickstoffkonzentration von 21 Atom-% ergab, kann die Maßzahl weiter auf 0,37 verringert werden.

### Beispiel 4 (Probe N6; Vergleichsbeispiel)

Es wird ein Quarzglas aus natürlichem Rohstoff hergestellt. Dem Quarzkristall wird zusätzlich pulverförmiges Al₂O₃ beigemischt. Das Pulvergemisch wird in einem Verneuil-Verfahren unter Einsatz eine wasserstoffhaltigen Brennerflamme zu einer Quarzglasstange erschmolzen und diese anschließend anhand mehrerer Umformschritte zu einem Quarzglasring geformt.

Die Menge an Al₂O₃-Pulver ist so bemessen, dass sich im erschmolzenen Quarzglas ein Al-Gehalt von 5000 Gew.-ppm einstellt. Allerdings ist der Hydroxylgruppengehalt des Quarzglases mit 145 Gew.-ppm herstellungsbedingt hoch.

Dennoch zeigt das Quarzglas eine sehr gute Trockenätzbeständigkeit, die aber ausschließlich auf den sehr hohen Al-Gehalt zurückzuführen ist. Der hohe Al-Gehalt kann sich je nach Einsatzzweck des Quarzglas-Halters 1 ungünstig auf den Halbleiterfertigungsprozess auswirken.

Ähnliches gilt für die Probe N5 mit einem noch höheren Al-Gehalt.

Die Quarzglas-Proben N3 und N4 werden nach dem gleichen Schmelzverfahren wie die Proben N5 und N6 hergestellt, unterscheiden sich aber von diesen durch einen deutlich geringeren Al-Gehalt und untereinander durch unterschiedliche Maßnahmen für die Nachbehandlung der Oberfläche. Die daraufhin gemessenen Maßzahlen für die Trockenätzbeständigkeit sind aus der Tabelle zu entnehmen.

### Beispiel 5 (Probe N8)

Das Quarzglas der Probe N8 wird erhalten, indem natürlicher Rohstoff in einem Tiegelziehverfahren zu einem Strang gezogen und dieser in mehreren Verfahrensschritten zu dem Quarzglas-Halter umgeformt und abschließend mechanisch auf Endmaß bearbeitet wird, wie oben anhand Beispiel 1 erläutert.

Das so erhaltene Quarzglas entspricht dem bisherigen Standardmaterial für die Herstellung von Wafer-Haltern und zeigt demgemäß eine Maßzahl von 1 für sein Trockenätzverhalten.

Nach dem Glätten der Oberfläche durch lang andauerndes Ätzen in HF-Lösung erfolgt eine Stickstoffdotierung der Oberfläche unter Einwirkung eines Hochtemperatur-Plasmas unter Ammoniak. Das Plasma wird durch Mikrowellenanreguung mit einer Frequenz von 2,45 GHz bei einer Leistung von 1000 Watt angeregt. Die Oberfläche wird dabei unterhalb der Plasmazone rotiert und verschoben, so dass sich eine spiralförmige Abrasterung über der plane Oberfläche ergibt. Dabei wird die Quarzglas-Oberfläche lokal erhitzt und erweicht. Gleichzeitig wird das Ammoniakgas im Plasma zersetzt und es kommt zu einem Einbau von Stickstoff in das Quarzglas der oberflächennahen Schicht. Durch XPS-Messung ergibt sich in einem oberflächennahen Schichtdickenbereich von 5 nm bis 10 nm eine Stickstoffkonzentration von 23 Atom-%.

Der so behandelte Quarzglas-Halter 1 zeichnet sich durch eine sehr gute Trockenätzstabilität mit einer Maßzahl von 0,56 aus.

Die Probe N7 unterscheidet sich in ihrer stofflichen Zusammensetzung von der Probe N8 insbesondere im Hydroxylgruppengehalt. Dieses Quarzglas wird aus natürlichem Quarz durch Lichtbogenschmelzen unter Grob-Vakuum hergestellt. Die Quarzkörnung wird hierzu an der Innenwandung einer um ihre Längsachse rotierenden Schmelzform fixiert und mittels eines im Innern gezündeten Lichtbogens aufgeschmolzen. Die Weiterverarbeitung des so erhaltenen Rohres erfolgt durch Umformen in mehreren Verfahrensschritten und einer abschließenden mechanischen Endbearbeitung, wie oben anhand Beispiel 1 erläutert.

### Beispiel 6 (Probe S4)

Es wird ein Quarzglas-Halter 1 aus synthetischem SiO₂ hergestellt, indem anhand des bekannten OVD-Verfahrens durch Flammenhydrolyse von SiCl₄ ein poröser SiO₂-Sootkörper erzeugt wird. Dieser wird einer Dehydratationsbehandlung unter chlorhaltiger Atmosphäre unterzogen. Der Sootkörper wird unter Ammoniak verglast, wie dies in der DE 695 29 824 T2 näher erläutert ist. Nach dem Verglasen wird ein rohrförmiger Quarzglaskörper mit einem Hydroxylgruppengehalt von weniger als 1 Gew.-ppm und mit einem mittleren Stickstoffgehalt von 0,4 Atom-% erhalten. Zur Herstellung eines Quarzglas-Halters im Sinne der Erfindung wird vom Quarzglas-Rohr ein Ring abgetrennt.

Zur Einstellung einer fiktiven Temperatur von etwa 1065 °C wird der Halter einer Temperbehandlung unterzogen, die eine Haltezeit von 4 Stunden bei einer Temperatur von 1060 °C und ein anschließendes langsames Abkühlen von dieser Temperatur auf 400 °C umfasst. Der Quarzglas-Halter 1 zeichnet sich durch eine gute Trockenätzbeständigkeit aus (Maßzahl = 0,88), die durch ein anschließendes Glätten der Oberfläche mittels Laser noch auf eine Maßzahl von 0,66 und durch eine zusätzliche Stickstoffdotierung des oberflächennahen Bereichs auf 0,58 verbessert werden kann.

Die in Tabelle 1 genannten Proben S2 und S3 bestehen ebenfalls aus synthetischem Quarzglas, wobei sich die jeweiligen Hydroxylgruppengehalte aufgrund unterschiedlich intensiver Dehydratationsbehandlungen und die jeweiligen fiktiven Temperaturen wegen unterschiedlicher Temperbehandlungen unterscheiden.

### Beispiel 7 (Probe S3)

Bei dem Quarzglas der Probe S3 handelt es sich um synthetisches Quarzglas, das sich durch einen geringen Hydroxylgruppengehalt von 28 Gew.-ppm und durch geringe Halogengehalte auszeichnet. In Verbindung mit einer hydroxylgruppenfreien, laserunterstützen Glättung der Oberfläche mit Stickstoffdotierung zeigt das Quarzglas bei einer Temperatur von 1200 °C eine Viskosität von 1X10^{13,4} dPa·s und damit einhergehend auch eine hohe Trockenätzbeständigkeit mit einer Maßzahl von 0,37.

### Beispiel 8 Probe S2)

Auch bei dem Quarzglas der Probe S2 handelt es sich um synthetisches Quarzglas. Dieses zeichnet sich durch eine Glasstruktur ohne Sauerstoff-Fehlstellen aus, einen mittleren Gehalt an SiH-Gruppen von weniger als 5x10¹⁶ Molekülen/cm³, einen mittleren Gehalt an Hydroxylgruppen von 5 Gew.-ppm, einen mittleren Gehalt an Fluor von 5 Gew.-ppm, einen mittleren Gehalt an Chlor von weniger als 1 Gew.-ppm, sowie durch eine fiktive Temperatur von 1080 °C. Die Viskosität des Quarzglases und weitere Eigenschaften ergeben sich aus Tabelle 1.

Unter einer Glasstruktur, die im wesentlichen frei von Sauerstoff-Fehlstellen ist, wird hier eine Glasstruktur verstanden, bei der die Konzentration von Sauerstoff-Unterschussdefekten unterhalb der Nachweisbarkeitsgrenze der Methode von Shelby liegt (minimal etwa 10¹⁷ pro Gramm Quarzglas). Diese Nachweismethode ist veröffentlicht in "Reaction of hydrogen with hydroxyl-free vitreous silica" (J. Appl. Phys., Vol. 51, No. 5 (Mai 1980), S. 2589-2593).

Der Gehalt an SiH-Gruppen wird mittels Raman-Spektroskopie ermittelt, wobei eine Kalibrierung anhand einer chemischen Reaktion erfolgt: Si-O-Si + H₂ → Si-H + Si-OH, wie in Shelby "Reaction of hydrogen with hydroxyl-free vitreous silica" (J. Appl. Phys., Vol. 51, No. 5 (Mai 1980), S. 2589-2593) beschrieben.

Das synthetische Quarzglas der Probe S2 wird erzeugt, indem ein Sootkörper durch Flammenhydrolyse von SiCl₄ anhand des bekannten VAD-Verfahrens hergestellt wird. Der Sootkörper wird bei einer Temperatur von 1200 °C in einem Heizofen mit einem Heizelement aus Grafit unter Vakuum dehydratisiert, so dass sich ein Hydroxylgruppengehalt des Sootkörpers von etwa 5 Gew.-ppm einstellt. Der getrocknete Sootkörper wird anschließend in einen Sinterofen eingebracht und bei einer Temperatur von ca. 1750 °C unter Vakuum (10⁻² mbar) zu einem transparenten Quarzglasrohling verglast. Dieser wird anschließend durch thermisch mechanische Homogenisierung (Verdrillen) und Bildung eines Quarzglas-Zylinders homogenisiert. Der Hydroxylgruppengehalt des Quarzglas-Zylinder beträgt danach weiterhin ca. 5 Gew.-ppm.

### Beispiel 9 (Vergleichsbeispiel; Probe S1)

Bei der Probe S1 wird das synthetische Quarzglas durch sogenanntes "Direktverglasen" erzeugt. Der Hydroxylgruppengehalt ist dabei so hoch, das auch eine anschließende Stickstoffdotierung der Oberfläche nicht ausreichte, um die Viskosität des Quarzglases bei 1200 °C über einen Wert vom 1x10¹³ dPa·s zu erhöhen, so dass auch die Trockenätzbeständigkeit dieses Quarzglases nicht gegenüber dem Standardmaterial verbessern werden konnte (Maßzahl = 1,08).

**Figur 2** zeigt ein auf Basis des Diffusionskoeffizienten berechnetes Diffusionsprofil für die Eindiffusion von Stickstoff von der Oberfläche eines Quarzglas-Halters aus. Auf der x-Achse ist die Stickstoffkonzentration C(N₂) in relativen Einheiten angetragen - die lokale Stickstoff-Konzentration in der Tiefe "D" bezogen auf die Stickstoff-Konzentration unmittelbar an der Oberfläche - und auf der x-Achse die Tiefe "D" von der Oberfläche aus gemessen in µm. Bei bekanntem Konzentrationswert im Bereich der Oberfläche ergibt sich anhand des Konzentrationsprofils die lokale Konzentration im Bereich der oberflächennahen Schicht bis zu einer Tiefe von etwa 50 µm.

**Tabelle 1**

| **Eigenschaften** | **Quarzglas - Qualitäten** | | | | | | | | | | | |
|---|---|---|---|---|---|---|---|---|---|---|---|---|
| | **S1** | **S2** | **S3** | **S4** | **N1** | **N2** | **N3** | **N4** | **N5** | **N6** | **N7** | **N8** |
| Qualität: syn. / nat. | synthet. | synthet. | synthet. | synthet. | natürlich | natürlich | natürlich | natürlich | natürlich | natürlich | natürlich | natürlich |
| Herstellungsverfahren | DQ-Verfahren | Sootver-fahren 1 | Sootver-fahren 2 | Sootver-fahren 3 | Vakuum-Schmelz. | Vakuum-Schmelz | Flammenschmelz. | Flammenschmelz | Flammenschmelz | Flammenschmelz | Lichtbogen | Mehrstufenverf. |
| Mittl. OH-Gehalt [Gew.ppm] | 1200 | 5 | 28 | < 1 | < 1 | 4 | 160 | 156 | 150 | 145 | 9 | 25 |
| Mittl. F-Gehalt [Gew.ppm] | 1230 | 5 | 40 < | 0.5 | < 50 | < 50 | < 50 | < 50 | < 50 | < 50 | < 50 | < 50 |
| Mittl. Cl-Gehalt [Gew.ppm] | 20 | < 1 | 20 | 1500 | < 60 | < 60 | < 60 | < 60 | < 60 | < 60 | < 60 | < 60 |
| SiH-Gruppen [1/cm3] | 6.9E18 | <1 E17 | < 1E17 | < 1E17 | < 1E17 | < 1 E17 | 2.2E18 | 2.2E18 | < 1E17 | < 1 E17 | 2.7E17 | < 1E17 |
| Si-Si-Gruppen [@163nm, 1/cm] | 0.65 | <0.5 | < 0.5 | < 0.5 | < 0.5 | < 0.5 | < 0.5 | < 0.5 | < 0.5 | < 0.5 | < 0.5 | < 0.5 |
| Na- / K- Gehalt [Gew.ppm] | 0.01 /0.02 | 0.01 /0.01 | 0.01 /0.01 | 0.01 /0.01 | 0.05/0.0 8 | 0.05/0.1 | 0.05/0.2 | 0.04/0.7 | 0.01 /0.0 1 | 0.01 /0.0 1 | 0.1 /0.15 | 0.02/0.1 |
| Al-Gehalt [Gew.ppm] | < 0.05 | < 0.05 | < 0.05 | < 0.05 | 15 | 15 | 8 | 16 | 15000 | 5000 | 18 | 15 |
| mittlerer Stickstoff-Gehalt [at.%] | - | - | - | 0,4 | - | - | - | - | - | - | - | - |
| Viskosität [dPa·s] ggf. nach N-Dot. | 1E10.8 | 1E12.0 | 1E13.4 | 1E13.1 | 1E13.6 | 1E13.6 | 1E11.8 | 1E13.2 | 1E10.3 | 1E10.8 | 1 E13.4 | 1E13.5 |
| Fiktive Temperatur [Grad C] | 1290 | 1080 | 1142 | 1065 | 1170 | 1160 | 1369 | 1283 | 1190 | 1220 | 1240 | 1148 |
| **Maßzahl für das Trockenätzverhalten** | **1,19** | **0,85** | **0,89** | **0,88** | **0,74** | **0,82** | **1,06** | **0,96** | **0,28** | **0,51** | **0,87** | **1,00** |
| **+ Ätzen 1440 min** | **-** | **0,69** | **-** | **-** | **0,59** | **-** | **0,85** | **0,77** | **-** | **-** | **0,70** | **0,80** |
| **+ Laser-Glättung** | **1,08** | **-** | **0,67** | **0,66** | **-** | **0,67** | **-** | **-** | **-** | **-** | **-** | **-** |
| **+ Stickstoff-Dotlerung** N₂-Gehalt [at-%] (XPS) | | | **0,37** / 26 | | **0,33** / 20 | **0,37** / 21 | | **0,64** / 26 | | | **0,38** / 26 | **0,56** / 23 |
| Endergebnis | 1,08 | 0,69 | 0,37 | 0,66 | 0,33 | 0,37 | 0,85 | 0,64 | 0,28 | 0,51 | 0,38 | 0,56 |

## Patentansprüche

1. Halter aus Quarzglas für die Prozessierung von Halbleiterwafern, wobei das Quarzglas mindestens in einem oberflächennahen Bereich mit Stickstoff dotiert ist und einen mittleren Gehalt an metastabilen Hydroxylgruppen von weniger als 30 Gew.-ppm aufweist, **dadurch gekennzeichnet dass** seine fiktive Temperatur unterhalb von 1250 °C und seine Viskosität bei einer Temperatur von 1200°C mindestens 10¹³ dPa·s betragen.

2. Halter nach Anspruch 1, **dadurch gekennzeichnet, dass** das Quarzglas aus natürlich vorkommendem SiO₂-Rohstoff erschmolzen ist, und dass der mittlere Gehalt an metastabilen Hydroxylgruppen weniger als 5 Gew.-ppm beträgt.

3. Halter nach Anspruch 1 oder 2, **dadurch gekennzeichnet, dass** der mittlere Gehalt an metastabilen Hydroxylgruppen maximal 1 Gew.-ppm beträgt.

4. Halter nach Anspruch 1, **dadurch gekennzeichnet, dass** das Quarzglas aus synthetisch erzeugtem SiO₂ erschmolzen ist und einen mittleren Stickstoffgehalt von mindestens 0,1 Atom-% aufweist.

5. Halter nach einem der vorhergehenden Ansprüche, **dadurch gekennzeichnet, dass** das Quarzglas einen Gehalt an Fluor von weniger als 50 Gew.-ppm aufweist.

6. Halter nach einem der vorhergehenden Ansprüche, **dadurch gekennzeichnet, dass** das Quarzglas einen Gehalt an Chlor von weniger als 60 Gew.-ppm aufweist.

7. Halter nach einem der vorhergehenden Ansprüche, **dadurch gekennzeichnet, dass** das Quarzglas einen Gehalt an SiH-Gruppen unterhalb von 1x10¹⁷ pro cm³ Glas aufweist.

8. Halter nach einem der vorhergehenden Ansprüche, **dadurch gekennzeichnet, dass** das Quarzglas für UV-Strahlung einer Wellenlänge von 163 nm eine Absorption von weniger als 0,5/cm aufweist.

9. Halter nach einem der vorhergehenden Ansprüche, **dadurch gekennzeichnet, dass** der Gehalt an Na und K im Quarzglas jeweils weniger als 500 Gew.-ppb beträgt.

10. Halter nach einem der vorhergehenden Ansprüche, **dadurch gekennzeichnet, dass** das Quarzglas mindestens im oberflächennahen Bereich Aluminiumoxid enthält, wobei der Al-Gehalt im Bereich zwischen 5.000 Gew.-ppm und 20.000 Gew.-ppm liegt.

11. Verfahren zur Herstellung eines Halters aus Quarzglas für den Einsatz in der Halbleiterfertigung nach einem der vorhergehenden Ansprüche, **gekennzeichnet durch**
• ein Bereitstellen von SiO₂-Rohstoff in Teilchenform, vorzugsweise aus natürlich vorkommendem Rohstoff,
• ein Schmelzen oder Sintern des SiO₂-Rohstoffs zu einem Quarzglas-Rohling, wobei der SiO₂-Rohstoff oder der Quarzglas-Rohling einer Entwässerungsmaßnahme unterzogen werden,
• ein Erhitzen des SiO₂-Rohstoffs oder des Quarzglas-Rohlings auf eine Nitridierungstemperatur im Bereich zwischen 1050 °C und 1850 °C unter einer Ammoniak enthaltenden Atmosphäre,
• eine Temperaturbehandlung, mittels der das Quarzglas des Quarzglas-Rohlings auf eine fiktive Temperatur von 1250 °C oder weniger eingestellt wird,
• eine Oberflächenbehandlung des Quarzglas-Rohlings unter Bildung des Quarzglas-Halters.

12. Verfahren nach Anspruch 11, **dadurch gekennzeichnet, dass** die Nitridierungstemperatur beim Erhitzen des SiO₂-Rohstoffs oder des Quarzglas-Rohlings maximal 1250 °C beträgt.

13. Verfahren nach Anspruch 11 oder 12, **dadurch gekennzeichnet, dass** die Entwässerungsmaßnahme ein Schmelzen oder Sintern des SiO₂-Rohstoffs in einer grafithaltigen Form umfasst.

14. Verfahren nach einem der Ansprüche 11 bis 13, **dadurch gekennzeichnet, dass** die Entwässerungsmaßnahme ein Schmelzen oder Sintern des SiO₂-Rohstoffs in einer wasserfreien Atmosphäre oder unter Vakuum umfasst.

15. Verfahren nach einem der Ansprüche 11 bis 14, **dadurch gekennzeichnet, dass** die Entwässerungsmaßnahme ein Tempern des Quarzglas-Rohlings unter Vakuum umfasst.

16. Verfahren nach einem der Ansprüche 11 bis 15, **dadurch gekennzeichnet, dass** die Entwässerungsmaßnahme das Erhitzen des SiO₂-Rohstoffs oder des Quarzglas-Rohlings auf die Nitridierungstemperatur unter Ammoniak-Atmosphäre umfasst.

17. Verfahren nach einem der Ansprüche 11 bis 16, **dadurch gekennzeichnet, dass** die Oberflächenbehandlung ein Erhitzen der Rohling-Oberfläche, unter Einsatz eines auf die Oberfläche lokal einwirkenden Laserstrahls oder Hochtemperatur-Plasmas umfasst.

18. Verfahren nach einem der Ansprüche 11 bis 17, **dadurch gekennzeichnet, dass** die Oberflächenbehandlung eine mechanische Oberflächenbearbeitung umfasst, wodurch eine anfängliche mittlere Oberflächenrauigkeit R_{a,0} von 0,2 µm oder mehr eingestellt wird, und wobei von der durch mechanische Bearbeitung erhaltenen Oberfläche in einer anschließenden Ätzbehandlung mindestens 10 µm abgetragen werden.

## Claims

1. A quartz glass jig for processing semiconductor wafers, whereby the quartz glass is doped with nitrogen at least in a near-surface area and having a mean content of metastable hydroxyl groups of less than 30 wt ppm **characterized in that** the quartz glass having a fictive temperature below 1250°C and a viscosity of at least 10¹³ dPa·s at a temperature of 1200°C.

2. The jig according to claim 1, **characterized in that** the quartz glass is molten from naturally occurring SiO₂ raw material and that the mean content of metastable hydroxyl groups is less than 5 wt ppm.

3. The jig according to claim 1 or 2, **characterized in that** the mean content of metastable hydroxyl groups is not more than 1 wt ppm.

4. The jig according to claim 1, **characterized in that** the quartz glass is molten from synthetically produced SiO₂ and has a mean nitrogen content of at least 0.1 atom %.

5. The jig according to any one of the preceding claims, **characterized in that** the quartz glass has a content of fluorine of less than 50 wt ppm.

6. The jig according to any one of the preceding claims, **characterized in that** the quartz glass has a content of chlorine of less than 60 wt ppm.

7. The jig according to any one of the preceding claims, **characterized in that** the quartz glass has a content of SiH groups below 1x10¹⁷ per cm³ glass.

8. The jig according to any one of the preceding claims, **characterized in that** the quartz glass has absorption of less than 0.5/cm for UV radiation of a wavelength of 163 nm.

9. The jig according to any one of the preceding claims, **characterized in that** any Na and K present in the quartz glass is less than 500 wt ppb.

10. The jig according to any one of the preceding claims, **characterized in that** the quartz glass contains aluminum oxide at least in the near-surface area, the Al content ranges from 5,000 wt ppm to 20,000 wt ppm.

11. A method for producing a quartz glass jig for use in semiconductor production according to any one of the preceding claims, **characterized by**
• providing SiO₂ raw material in particle form, preferably from naturally occurring raw material,
• melting or sintering the SiO₂ raw material to obtain a quartz glass blank, the SiO₂ raw material or the quartz glass blank being subjected to a dehydration measure,
• heating the SiO₂ raw material or the quartz glass blank to a nitriding temperature in the range between 1050°C and 1850°C in an ammoniacontaining atmosphere,
• a temperature treatment by means of which the quartz glass of the quartz glass blank is set to a fictive temperature of 1250°C or less,
• a surface treatment of the quartz glass blank so as to form the quartz glass jig.

12. The method according to claim 11, **characterized in that** the nitriding temperature during heating of the SiO₂ raw material or the quartz glass blank is not more than 1250°C.

13. The method according to claim 11 or 12, **characterized in that** the dehydration measure comprises melting or sintering of the SiO₂ raw material in a graphite-containing mold.

14. The method according to any one of claims 11 to 13, **characterized in that** the dehydration measure comprises melting or sintering of the SiO₂ raw material in a water-free atmosphere or in vacuum.

15. The method according to any one of claims 11 to 14, **characterized in that** the dehydration measure comprises annealing of the quartz glass blank in vacuum.

16. The method according to any one of claims 11 to 15, **characterized in that that** the dehydration measure comprises heating of the SiO₂ raw material or the quartz glass blank to the nitriding temperature in an ammonia atmosphere.

17. The method according to any one of claims 11 to 16, **characterized in that** the surface treatment comprises heating of the blank surface, using a laser beam locally acting on the surface or high-temperature plasma.

18. The method according to any one of claims 11 to 17, **characterized in that** the surface treatment comprises a mechanical surface treatment, in which an initial mean surface roughness R_{a,0} of 0.2 µm or more is set, and wherein in a subsequent etching treatment at least 10 µm are removed from the surface obtained by the mechanical treatment.

## Revendications

1. Support en verre de quartz destiné au traitement de plaquettes à semi-conducteurs, le verre de quartz étant dopé au moins dans une zone proche de la surface d'azote et présentant une teneur moyenne en groupes hydroxyles métastables inférieure à 30 ppm en poids, **caractérisé en ce que** sa température fictive est inférieure à 1250°C et sa viscosité s'élève à au moins 10¹³ dPa·s à une température de 1200°C.

2. Support selon la revendication 1, **caractérisé en ce que** le verre de quartz est fondu à partir de matière première SiO₂ naturelle et **en ce que** la teneur moyenne de groupes métastables hydroxyles est inférieure à 5 ppm en poids.

3. Support selon la revendication 1 ou 2, **caractérisé en ce que** la teneur moyenne de groupes métastables hydroxyles est de maximum 1 ppm en poids.

4. Support selon la revendication 1, **caractérisé en ce que** le verre de quartz est fondu à partir de SiO₂ synthétique et présente une teneur moyenne en azote d'au moins 0,1 pourcent d'atome.

5. Support selon l'une des revendications précédentes, **caractérisé en ce que** le verre de quartz présente une teneur en fluor inférieure à 50 ppm en poids.

6. Support selon l'une des revendications précédentes, **caractérisé en ce que** le verre de quartz présente une teneur en chlore inférieure à 60 ppm en poids.

7. Support selon l'une des revendications précédentes, **caractérisé en ce que** le verre de quartz présente une teneur en groupes SiH inférieure à 1x10¹⁷ par cm³ de verre.

8. Support selon l'une des revendications précédentes, **caractérisé en ce que** le verre de quartz présente pour le rayonnement UV d'une longueur d'onde de 163 nm une absorption inférieure à 0,5/cm.

9. Support selon l'une des revendications, **caractérisé en ce que** la teneur en Na et K dans le verre de quartz est respectivement inférieure 500 ppb en poids.

10. Support selon l'une des revendications précédentes, **caractérisé en ce que** le verre de quartz contient, au moins dans la zone proche de la surface supérieure, de l'oxyde d'aluminium, la teneur en Al étant comprise entre 5.000 ppm en poids et 20.000 ppm en poids.

11. Procédé pour la fabrication d'un support en verre de quartz pour l'emploi dans la fabrication de semi-conducteurs selon l'une des revendications précédentes **caractérisé par**
• une mise à disposition de matière première SiO₂ sous forme de particules de préférence d'origine naturelle,
• une fusion ou frittage de la matière première SiO₂ en une ébauche de verre de quartz, la matière première SiO₂ ou l'ébauche de verre de quartz étant soumise à une mesure de déshydratation,
• un chauffage de la matière première SiO₂ ou de l'ébauche de verre de quartz à une température de nitrification comprise entre 1050°C et 1850°C dans une atmosphère contenant de l'ammoniac,
• un traitement thermique au moyen duquel le verre de quartz de l'ébauche de verre de quartz est amenée à une température fictive de 1250°C ou inférieure,
• un traitement de surface de l'ébauche de verre de quartz sous formation du support de verre de quartz.

12. Procédé selon la revendication 11, **caractérisé en ce que** la température de nitrification lors du chauffage de la matière première SiO₂ ou de l'ébauche de verre de quartz est de maximum 1250°C.

13. Procédé selon la revendication 11 ou 12, **caractérisé en ce que** la mesure de déshydratation comprend une fusion ou un frittage de la matière première de SiO₂ sous forme graphite.

14. Procédé selon l'une des revendications 11 à 13, **caractérisé en ce que** la mesure de déshydratation comprend une fusion ou un frittage de la matière première SiO₂ dans une atmosphère sans eau ou sous vide.

15. Procédé selon l'une des revendications 11 à 14, **caractérisé en ce que** la mesure de déshydratation comprend un maintien en température de l'ébauche de verre de quartz sous vide.

16. Procédé selon l'une des revendications 11 à 15, **caractérisé en ce que** la mesure de déshydratation comprend le chauffage de la matière première de SiO₂ ou de l'ébauche de verre de quartz à la température de nitrification sous atmosphère d'ammoniac.

17. Procédé selon l'une des revendications 11 à 16, **caractérisé en ce que** le traitement de surface comprend un chauffage de la surface de l'ébauche sous l'emploi d'un rayon laser agissant localement sur la surface ou en utilisant le plasma à haute température.

18. Procédé selon l'une des revendications 11 à 17, **caractérisé en ce que** le traitement de surface comprend un traitement de surface mécanique qui permet de régler une rugosité de surface initiale moyenne R_{a,0} est supérieure ou égale à 0,2 µm et au moins 10 µm sont enlevés de la surface obtenue par traitement mécanique dans un traitement ultérieur de mordançage.
